# EUROPEAN PATENT APPLICATION

(11) **EP 4 521 019 A2**
(43) Date of publication of application: **12.03.2025**
(21) Application number: 24194057.6
(22) Date of filing: 12.08.2024
(51) Int. Cl.: F21V 29/10, A61L 2/10, G03F 7/20, H01L 21/027, B08B 7/00

(54) **UV TREATMENT APPARATUS**

(30) Priority: 17.08.2023 JP 2023132796
(71) Applicant: Ushio Denki Kabushiki Kaisha, Tokyo 100-8150 (JP)
(72) Inventor: OKUMURA, Yutaka, Tokyo, 100-8150 (JP); YAMAMORI, Kenji, Tokyo, 100-8150 (JP); KOBAYASHI, Ryo, Tokyo, 100-8150 (JP); OZU, Masato, Tokyo, 100-8150 (JP)
(74) Representative: Maiwald GmbH

(57) **Abstract**

To provide a light treatment device that solves a problem caused by deflection of a housing. The light treatment device (100) includes: a light source (3) that irradiates a treatment object (4) conveyed along a conveyance path with ultraviolet light (L1); a housing (2a, 2b) having the light source (3) therein and having an opening (5i, 5o) through which the treatment object (4) is carried in or out; and a heat deflection reducer that reduces heat deflection of the housing (2a, 2b) surrounding the opening (5i, 5o).

## Description

### BACKGROUND OF THE INVENTION

### Field of the Invention

The present invention relates to a light treatment device.

### Description of the Related Art

There is known a light treatment device including a light source that emits light and a housing (lamp house) having the light source therein, in which light cleaning or light surface treatment is performed on a treatment object by irradiating the treatment object with light in the housing while conveying the treatment object so that the treatment object passes through the housing (see, for example, Patent Document 1).

### Prior Art Document

### Patent Document

Patent Document 1: JP-A-2006-108069

### SUMMARY OF THE INVENTION

In such a light treatment device, the light source emits light and also emits heat. There is a case where the housing surrounding the light source is heated and thermally expanded by heat emitted from the light source. It has been found that the thermal expansion of the housing causes problems such as the housing becoming deflected and interfering with a member disposed in the housing. Therefore, a light treatment device that reduces the deflection of the housing is to be considered.

As a result of intensive studies by the present inventors, it has been found that the deflection of the housing occurs concentratedly in a partial region of the housing. The region particularly easy to be deflected is a region surrounding an opening for carrying in or out the treatment object. This has led to the finding of the following light treatment device.

The light treatment device according to the present invention includes:
a light source that irradiates a treatment object conveyed along a conveyance path with ultraviolet light;
a housing having the light source therein and having an opening through which the treatment object is carried in or out; and
a heat deflection reducer that reduces heat deflection of the housing surrounding the opening.

The heat deflection of the housing is caused by heat generated by the light source or the like disposed in the housing being transferred to the housing. When the housing is heated, the housing expands. When the temperature rise of the housing spreads over a wide range, the entire housing is thermally expanded, and thus a large problem does not occur. However, when the heating of the housing does not spread and a temperature difference occurs between regions located close to each other, a difference occurs in the amount of thermal expansion to generate the heat deflection in the housing. Although details will be described later, the present inventors have found that a local temperature difference in the housing is large in a region surrounding the opening, and thus a difference in thermal expansion is large to cause the housing to be easily deflected. By providing the heat deflection reducer, the heat deflection in the housing can be reduced at the portion surrounding the opening, the portion being particularly easily deflected. With this configuration, the housing can be prevented from interfering with a member disposed in the housing.

The housing may include two or more housings. For example, the housing may include a first housing having a space in which the treatment object is irradiated with the ultraviolet light, and a second housing having the light source therein. The first housing and the second housing form a space by closing the openings thereof with each other. As described above, in a case where a plurality of housings forms a space by closing the openings thereof with each other, by separating the plurality of housings from each other, maintainability of members disposed inside the housings is improved. In the light treatment device, the opening may be provided in the second housing. The opening may be provided in the first housing.

The opening may have a shape that is short in the thickness direction of the treatment object and long in the width direction of the treatment object.

The second housing may include a band region sandwiched between the opening having the band shape and an end of the second housing.

The heat deflection reducer includes a plurality of aspects exemplified below. The heat deflection reducer may include at least one of aspects described below.

The band region may include a band member separate from a main body constituting a portion excluding the band region. The heat deflection reducer may include an engagement mechanism that loosely engages the band member with the main body. The engagement mechanism may allow the band member to release thermal expansion in an extending direction of the band member with respect to the main body, that is, may restrict shift in a direction orthogonal to the extending direction while allowing elongation of the band member.

The heat deflection reducer may include a heater that heats a region, in the first housing, facing the band region across the opening. The heater may include an electrically heated wire, a pipe through which a high-temperature fluid passes, a light source that emits infrared light, or the like.

The heat deflection reducer may include a cooler that cools the band region. The cooler may include a heat sink, a Peltier element, a cooling pipe through which a refrigerant flows, or a cooling fan.

The heat deflection reducer may have a light shield inserted between the band region and the light source. The light shield shields light directed from the light source toward the band region. Therefore, the thermal expansion of the band region caused by the band region being irradiated with light can be prevented.

An object of the present invention is to provide a light treatment device that solves at least one of the problems that have been conventionally experienced.

### BRIEF DESCRIPTION OF THE DRAWINGS

Fig. 1 is a cross-sectional view of a light treatment device;
Fig. 2A is a view of a housing as viewed from the upstream side to the downstream side in a conveyance direction;
Fig. 2B is a view of the housing as viewed from the upstream side to the downstream side in the conveyance direction;
Fig. 3 is a partially enlarged view of Fig. 1;
Fig. 4 is a cross-sectional view of the light treatment device including, as a heat deflection reducer, a light shield that suppresses light irradiation to a band region;
Fig. 5 is a view of a housing adopting another heat deflection reducer as viewed from the upstream side to the downstream side in the conveyance direction;
Fig. 6 is a view showing a configuration of a second housing of the housing in Fig. 5;
Fig. 7A is a view for explaining details of an engagement mechanism of the housing in Fig. 4;
Fig. 7B is a cross-sectional view along a line I-I in Fig. 7A;
Fig. 8A is a view for explaining a modification of the engagement mechanism of the housing;
Fig. 8B is a cross-sectional view along a line I-I in Fig. 8A; and
Fig. 9 is a diagram illustrating another embodiment of a light treatment device.

### DETAILED DESCRIPTION OF THE PREFERRED EMBODIMENTS

Embodiments of the present invention will be described with reference to the drawings. It should be noted that the drawings disclosed herein merely show schematic illustrations. That is, the dimensional ratios on the drawings do not necessarily reflect the actual dimensional ratios, and the dimensional ratios are not necessarily the same between the drawings. The number of each constituent illustrated in the drawings does not necessarily coincide with the actual number of each constituent.

Hereinafter, each of the drawings is described with reference to an XYZ coordinate system as appropriate. In describing directions herein, in a case where the positive or negative direction needs to be distinguished, the positive or negative symbol is added, such as the "+X direction" or the "-X direction". In a case where there is no need to distinguish between the positive and negative directions, the direction is simply described as the "X direction". Namely, in the present specification, in a case where the direction is simply described as "X direction", both "+X direction" and "-X direction" are included. The same applies to the Y direction and the Z direction. In the embodiments described below, the gravity direction is the -Z direction, the conveyance direction in which the treatment object is conveyed is the -Y direction, and the width direction of the treatment object is the X direction.

### [Outline of light treatment device]

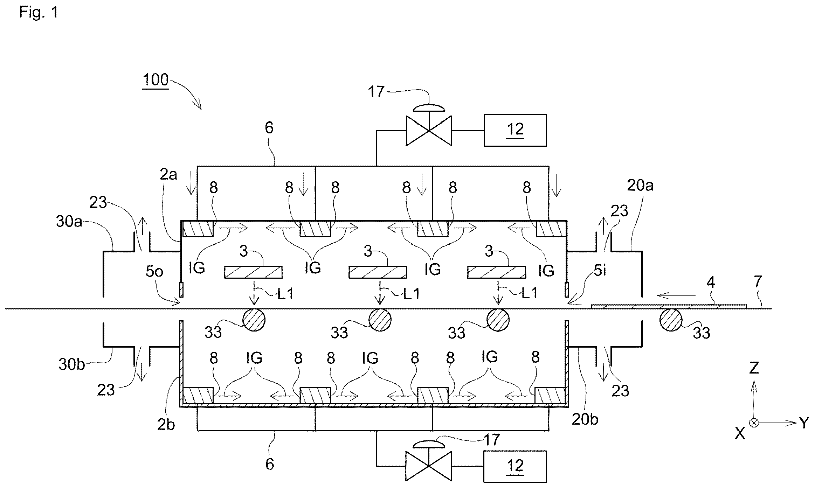

Fig. 1 is a cross-sectional view of a light treatment device illustrated as an example. The light treatment device 100 includes a light source 3 that irradiates a treatment object 4 with light L1, and a housing (2a, 2b) having the light sources 3 therein. The treatment object 4 is conveyed along the conveyance path. In the present embodiment, the conveyance path includes a belt 7 on which the treatment object 4 is placed. The treatment object 4 is placed on the belt 7 and conveyed together with the belt 7. The belt 7 is supported by rotatable guide rollers 33. From a different viewpoint, it can be said that the light treatment device 100 is disposed in the middle of the conveyance path. The emission direction of the light L1 from the light source 3 is the -Z direction. While the treatment object 4 is conveyed in the -Y direction along the conveyance path, the treatment object 4 is exposed to the light L1. Thus, the treatment object 4 is subjected to light treatment. The treatment content of the light treatment will be described later.

The housing (2a, 2b) includes a first housing 2a and a second housing 2b. Each of the first housing 2a and the second housing 2b has a box shape including one surface along the XY plane and four side surfaces surrounding the surface and along the XZ plane or the YZ plane. In the first housing 2a, one surface along the XY plane does not have a surface in a portion close to the treatment object 4. The second housing 2b also has a box shape including one surface along the XY plane and four side surfaces surrounding the surface and along the XZ plane or the YZ plane. In the second housing 2b, one surface along the XY plane does not have a surface in a portion close to the treatment object 4.

When the housing (2a, 2b) is closed such that portions without surfaces of the housing (2a, 2b) are close to each other, the housing (2a, 2b) form one space. The space is a treatment target space of the treatment object 4. In Fig. 1, the second housing 2b is indicated with a hatched region, and the first housing 2a is indicated by a thick line. However, this only indicates that the first housing 2a and the second housing 2b can be distinguished from each other, and does not necessarily indicate that the thickness of the second housing 2b is thicker than the thickness of the first housing 2a. The thickness of the second housing 2b and the thickness of the first housing 2a may be the same as or different from each other. The thickness of the second housing 2b may be thicker than the thickness of the first housing 2a, or the thickness of the first housing 2a may be thicker than the thickness of the second housing 2b.

After the housing (2a, 2b) is once closed, the housing (2a, 2b) can be opened again. Therefore, maintainability of members disposed inside the housing (2a, 2b) is improved. However, the housing may include a single housing that is not separated, or may include three or more housings.

The first housing 2a has a gas supply port 8. Similarly to the first housing 2a, the second housing 2b also has the gas supply port 8. By supplying the gas from the gas supply port 8, the gas entering from the outside of the treatment target space can be reduced. However, the gas supply port 8 is not an essential component for the light treatment device. Details of the gas supply port 8 will be described later.

The first housing 2a functions as a lamp house. Although not illustrated, the first housing 2a supports the light source 3. In the second housing 2b, the side surface is provided with a carry-in opening 5i through which the treatment object 4 is carried in, and a side surface facing this side surface is provided with a carry-out opening 5o through which the treatment object 4 is carried out. Each of the openings (5i and 5o) is an opening surrounded by the side surface of the second housing 2b. The openings are used as the conveyance path of the treatment object 4.

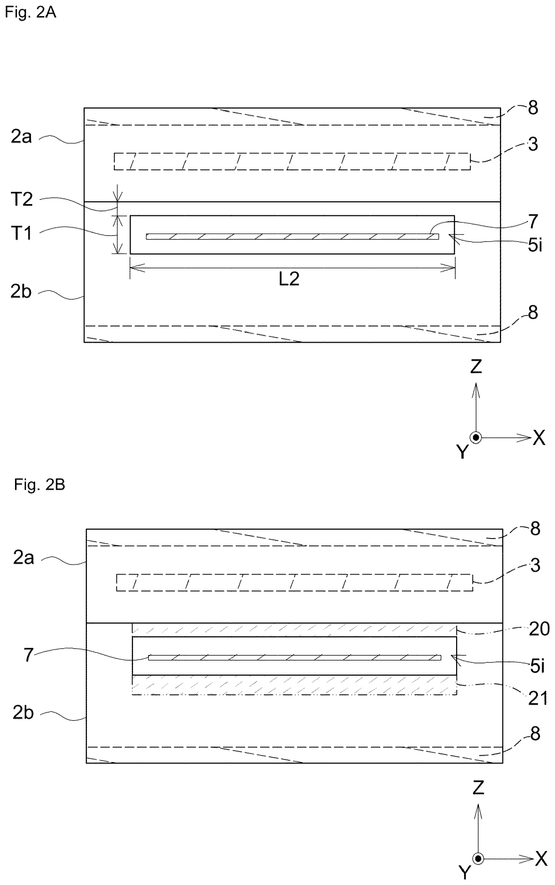

Fig. 2A is a view of the housing (2a, 2b) of the light treatment device 100 as viewed from the upstream side to the downstream side (-Y direction) in the conveyance direction. A gas recovery chamber to be described later is not illustrated. In Fig. 2A, because the light source 3 and the gas supply port 8 are not visible, the two are indicated by broken lines. The belt 7 on which the treatment object 4 can be placed is illustrated in cross section. In this drawing, the treatment object 4 is not illustrated.

As shown in Fig. 2A, the carry-in opening 5i has a shape that is short in the thickness direction (Z direction) of the treatment object 4 and long in the width direction (X direction) of the treatment object 4. A thickness T1 of the carry-in opening 5i is preferably, for example, 5 mm or more and 34 mm or less, and more preferably, 9 mm or more and 17 mm or less. A length L2 of the carry-in opening 5i is longer than the length of the belt 7 (or the treatment object 4). However, in order to suppress the amount of gas in the housing (2a, 2b) leaking from the carry-in opening 5i, the difference between the length of the carry-in opening 5i and the length of the belt 7 (or the treatment object 4) is preferably 14 mm or less. The shape of the carry-out opening 5o may be similar to or different from the shape of the carry-in opening 5i.

As described above, in the present embodiment, the second housing 2b has the carry-in opening 5i and the carry-out opening 5o. However, the first housing 2a may have at least one of the carry-in opening 5i and the carry-out opening 5o. Further, referring to Fig. 1, a state in which the first housing 2a includes the light source 3 therein and functions as a lamp house is illustrated, but the second housing 2b may include the light source 3 therein and function as a lamp house. Both the first housing 2a and the second housing 2b may have the light source 3 therein and function as a lamp house.

### [Heat deflection of housing]

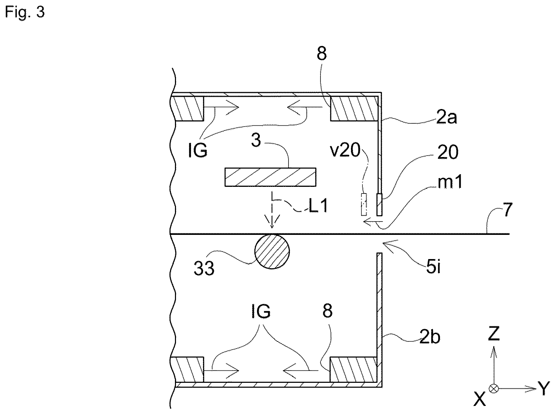

As described above, the light source 3 emits heat along with the radiation of the light L1. A housing (2a, 2b) surrounding the light source 3 is heated by the light source 3. When the housing (2a, 2b) is heated, the housing (2a, 2b) is thermally expanded. Problems associated with the thermal expansion of the housing (2a, 2b) will be described with reference to Figs. 2B and 3.

Similarly to Fig. 2A, Fig. 2B is a view of the housing (2a, 2b) as viewed from the upstream side to the downstream side (-Y direction) in the conveyance direction. In the second housing 2b, there is a band region 20 between the carry-in opening 5i and an end of the housing close to the first housing 2a. The band region 20 has a shape that is short in the Z direction and long in the X direction.

As illustrated in Fig. 1, the band region 20 is located at a position close to the light source 3. Therefore, the heat generated by the light source 3 is easily transferred to the band region 20. Because the band region 20 is adjacent to the carry-in opening 5i, the heat transferred to the band region 20 is not easily diffused through the second housing 2b and tends to be retained in the band region 20. Therefore, the temperature of the band region 20 rises easily. In addition, the small thickness T2 (see Fig. 2A) of the band region 20 also causes the temperature of the band region 20 to rise easily. On the other hand, because a region 21 (see Fig. 2B) facing the band region 20 across the carry-in opening 5i is far from the light source 3 and is separated from the band region 20 by the carry-in opening 5i, the amount of heat transferred from the band region 20 is small. Therefore, the temperature of the region 21 does not easily rise. As a result, two regions (20, 21) having different temperatures are present through the carry-in opening 5i.

The thickness T2 (see Fig. 2A) of the band region 20 is, for example, 5 mm or more and 80 mm or less. The thickness T2 is preferably 10 mm or more and 50 mm or less. By setting the thickness T2 short, the distance between the conveyance path of the treatment object 4 and the light source 3 becomes small, and thus, the treatment object 4 can be effectively irradiated with ultraviolet light. The length of the band region is the same as the length L2 of the carry-in opening 5i.

Fig. 3 is a partially enlarged view of Fig. 1. The heat deflection of the housing (2a, 2b) is caused by a difference in the amount of thermal expansion in the housing (2a, 2b) in which the amounts of temperature rise are different from each other. The band region 20 and the region 21 located close to each other across the carry-in opening 5i are easily subjected to heat deflection due to a difference in the amount of thermal expansion. Because the band region 20 has a shape elongated in one direction, the deflection amount is particularly large.

A region v20 in Fig. 3 indicates a position of the band region 20 deflected by thermal expansion. The region v20 is shifted in the -Y direction by m1 from the position where the region should originally be. As described above, when the band region 20 of the second housing 2b is shifted to the position of the region v20, there is a risk that the band region 20 comes into contact with another member (for example, a reflection member, a light source, and the like in the first housing 2a). In addition, a gap is formed between the band region 20 and the first housing 2a, and there is a risk that the inert gas in the first housing 2a leaks. In the present embodiment, a state in which the band region 20 is shifted in the -Y direction is illustrated, but there is a risk that the band region 20 is shifted in the +Y direction or shifted in the +Z direction or the -Z direction. Even in a case where such positional shift of the band region 20 occurs, there is a possibility that the band region comes into contact with another member constituting the light treatment device, the belt 7, or the treatment object 4, or a possibility that a gap occurs between the band region 20 and the first housing 2a.

### [Heat deflection reducer]

In order to reduce the above-described heat deflection, the light treatment device 100 includes the heat deflection reducer. By providing the heat deflection reducer, the heat deflection of the band region 20 is reduced, and the band region 20 is prevented from being shifted from the position where the region should originally be. The heat deflection reducer has various forms and will be described below.

The method of reducing the heat deflection of the band region 20 is roughly classified into two methods: a method of suppressing the thermal expansion itself of the band region 20 (first method); and a method of preventing the band region 20 from being deflected even if the band region 20 thermally expands (second method). There are various forms for each method.

A first method (method of suppressing the thermal expansion itself of the band region 20) will be described. The first method includes a cooling method of cooling the band region 20 and a light shielding method of shielding the band region 20 from light in order to suppress the thermal expansion itself of the band region 20. First, as the heat deflection reducer used to perform the first method, a cooler for the cooling method of cooling the band region 20 is described.

The cooler may include a heat sink, a cooling pipe, a Peltier element, or a cooling fan. As a specific example of the heat sink, it is conceivable to form irregularities on the surface of the band region 20 to facilitate heat dissipation. As a specific example of the cooling pipe, it is conceivable to dispose a cooling pipe that allows the refrigerant to flow therethrough in contact with the surface of the band region 20, in the vicinity of the surface, or inside the band region 20. As a specific example of the Peltier element, it is conceivable to dispose the Peltier element on the surface of the band region 20 and allow the heat to be absorbed from the band region 20 by using the Peltier element. As a specific example of the cooling fan, it is conceivable to dispose the cooling fan so as to send the cooling gas toward the band region 20 or dispose the cooling fan so as to suck the high temperature gas around the band region 20. A plurality of coolers can be disposed in any of the coolers, and a cooler obtained by appropriately combining these specific examples may be used.

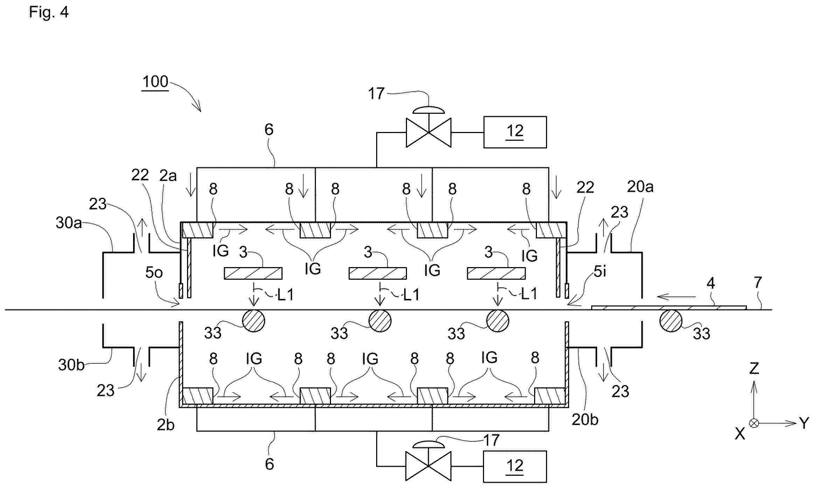

Next, as the heat deflection reducer for performing the first method, a light shielding method of shielding the band region 20 from light irradiation in order to suppress thermal expansion itself of the band region 20 will be described. The light treatment device includes a light shield 22 as the heat deflection reducer for performing the first method. As illustrated in Fig. 4, the light shield 22 is inserted between the band region 20 and the light source 3. The light shield 22 illustrated in Fig. 4 has a plate shape. The shape and disposition of the light shield 22 of the present embodiment are merely examples. The light shield 22 is not particularly limited as long as a function of shielding the band region 20 from the light from the light source 3 is included.

A second method (method of preventing the band region 20 from being deflected even if the band region 20 thermally expands) will be described. The second method includes a method in which the band region 20 releases thermal expansion in the extending direction and a method in which the region 21 facing the band region 20 across the carry-in opening 5i is heated.

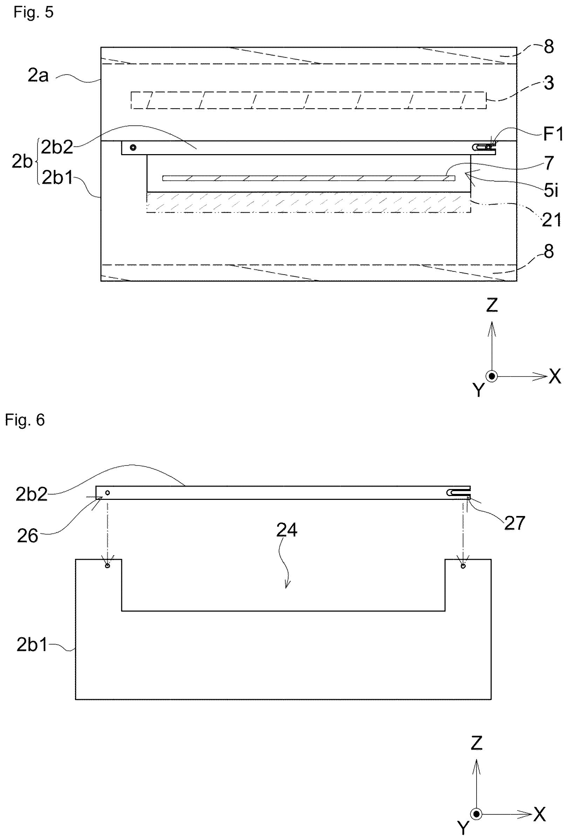

A method of allowing the band region 20 to release thermal expansion in the extending direction thereof will be described with reference to Figs. 5 and 6. Fig. 5 is a view of the housing (2a, 2b) as viewed from the upstream side to the downstream side (-Y direction) in the conveyance direction. Fig. 6 is a view illustrating only the second housing 2b in the present method. The second housing 2b includes a main body 2b1 and a band member 2b2 separate from the main body 2b1. The band region of the light treatment device 100 includes the band member 2b2. The main body 2b1 has a recess 24 on one side of the side surface. Further, as indicated by one dot chain line arrows directed in the -Z direction in Fig. 6, the band member 2b2 is moved and disposed so as to overlap a side having the recess of the main body 2b1. Thus, the carry-in opening 5i is formed.

An end 26 (see Fig. 6) of the band member 2b2 is fixed so as not to move with respect to the main body 2b1. An end 27 of the band member 2b2 is loosely engaged with the main body 2b1 so as to include play by an engagement mechanism F1 (see Fig. 5).

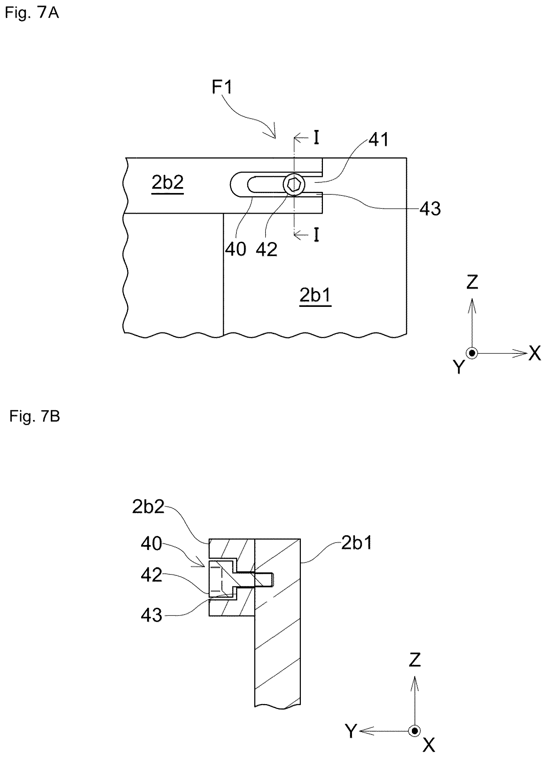

Details of the engagement mechanism F1 will be described with reference to Figs. 7A and 7B. Fig. 7A is a view for explaining details of the engagement mechanism of the housing in Fig. 4. Fig. 7B is a cross-sectional view along a line I-I in Fig. 7A. The band member 2b2 has a groove 40 along the longitudinal direction (X direction) thereof. The end 27 is loosely engaged with the main body 2b1 by using a head bolt 42 in a state where the band member 2b2 is expandable in the X direction. A through hole 41 and a flange 43 are provided inside the groove 40 provided in the end 27. The flange 43 constitutes a surface one step lower than the surface of the band member 2b2. A head portion of the head bolt 42 is larger than a gap between flanges 43 facing each other and smaller than the width of the groove 40. Further, the head bolt 42 is loosely tightened to such an extent that the head of the head bolt 42 does not touch the flange 43. This can suppress the shift of the band member 2b2 in the Y direction and the Z direction while releasing the expansion of the band member 2b2 in the X direction. Even when there is a difference in the amount of thermal expansion between the band member 2b2 and the main body 2b1, because the band member 2b2 is not pressed against the main body 2b1 and can freely thermally expand in the X direction with respect to the main body 2b1, the band member 2b2 is less likely to be deflected.

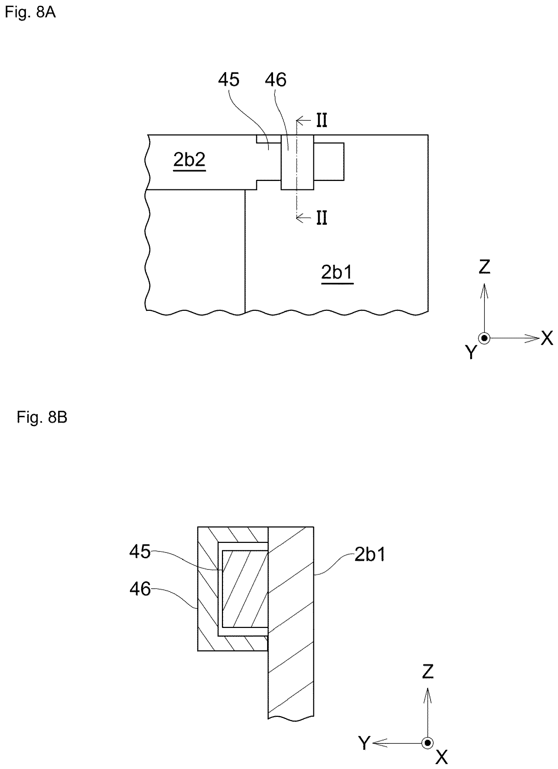

As an example of the engagement mechanism F1 including play, the mechanism constituted of the groove 40 including the flange 43 and the through hole 41 and the head bolt 42 has been described, but this engagement mechanism is merely an example and is not limited thereto. Fig. 8A is a view for explaining a modification of the engagement mechanism F1. Fig. 8B is a cross-sectional view along a line I-I in Fig. 8A. The engagement mechanism illustrated in this example includes a sliding guide 46 into which a portion 45 of the band member 2b2 can be inserted. The sliding guide 46 is attached to the main body 2b1. The portion 45 of the band member 2b2 is slidably inserted into a ring surrounded by the sliding guide 46 and the main body 2b1. As illustrated in Fig. 8A, the portion 45 is preferably formed thinner than the other portion of the band member 2b2. Even in the engagement mechanism having the sliding guide 46, the shift of the band member 2b2 in the Y direction and the Z direction can be suppressed while the expansion of the band member 2b2 in the X direction is released.

In the present embodiment and the modification, only the end 27 among the ends 26 and 27 of the band member 2b2 is the engagement mechanism F1 that provides loose engagement, and the end 26 is fixed. However, both the ends 26 and 27 may be provided with the engagement mechanism that provides loose engagement.

The band member 2b2 may be constituted of the same material (for example, an aluminum-based material) as the main body 2b1. The band member 2b2 may be constituted of a material different from that of the main body 2b1. In a case where the band member 2b2 is constituted of a material different from the material of the main body 2b1, it is preferable to employ a material in which the linear expansion coefficient of the band member 2b2 is smaller than the linear expansion coefficient of the main body 2b1 (in particular, the region 21). In addition, the band member 2b2 that is separate from the main body 2b1 has been described above, but the band member 2b2 may be integrated with the main body 2b1. For example, a mode may be adopted in which the band region is integrally formed with the main body 2b1 and protrudes from the end 26 toward the end 27.

A method of heating the region 21 will be described. As described above, in a case where the amount of thermal expansion amount is different between the band region 20 and the region 21, the band region 20 long in the X direction is easily deflected by heat. Therefore, the region 21 is heated, and the amount of thermal expansion in the region 21 is brought close to the amount of thermal expansion of the band region 20. That is, the heat deflection reducer for realizing the heating method is preferably a heater that heats the region 21. The region 21 is heated by the heater to bring the region 21 close to the temperature of the band region 20. When the temperature difference between the region 21 and the band region 20 becomes small, and the amount of thermal expansion in both the regions approaches each other and the difference in the amount of thermal expansion becomes small, the deflection of the band region 20 is suppressed.

As a specific example of the heater, an electrically heated wire or a temperature control tube for causing a temperature control fluid to flow may be disposed on the surface or inside of the region 21, or the surface of the region 21 may be irradiated with heat generation light.

The method of cooling the band region 20 (hereinafter, referred to as a "cooling method") and the light shielding method have been described as the first method, and the method of releasing the expansion of the band region 20 or the region 21 provided as the band member 2b2 (hereinafter, referred to as an "expansion releasing method") and the method of heating the region 21 facing the band region 20 (hereinafter, referred to as a "heating method") have been described as the second method. Any one of these methods may be applied, or a plurality of methods may be applied. That is, the cooling method and the expansion releasing method may be adopted, the cooling method and the heating method may be adopted, the expansion releasing method and the heating method may be adopted, or the four methods of the cooling method, the light shielding method, the expansion releasing method, and the heating method may be adopted. Although it has been described that the heat deflection reducer is provided for the second housing 2b surrounding the carry-in opening 5i, the heat deflection reducer described above may also be provided for the second housing 2b surrounding the carry-out opening 5o.

### [Light source]

The light source 3 will be described with reference to Fig. 1. The light source 3 emits the light L1 having a predetermined wavelength. The wavelength is set according to treatment content of the treatment object. The treatment content includes surface modification, cleaning, exposure, processing, and the like of the treatment object. The light L1 of the present embodiment is vacuum ultraviolet light, that is, ultraviolet light having light belonging to a wavelength band of at least a wavelength of 205 nm or less. As used herein, "light belonging to a wavelength band of at least a wavelength of 205 nm or less" is light having an emission intensity of at least 205 nm or less in an emission spectrum of the light source 3. Examples of such light include (1) light exhibiting intensity in a broad wavelength region and showing an emission spectrum whose peak emission wavelength of maximum intensity is 205 nm or less, (2) light showing an emission spectrum having a plurality of maximum intensities (a plurality of peaks), in which any one of the plurality of peaks is located in a wavelength range of 205 nm or less, and (3) light showing an emission spectrum in which integrated intensity of light at 205 nm or less is at least 30% of total integrated intensity. Note that the light to be used may not be the vacuum ultraviolet light.

In the present embodiment, the light source 3 is a dielectric barrier discharge lamp filled with xenon gas. However, the light source 3 may be a dielectric barrier discharge lamp filled with gas other than xenon gas. The light source 3 may be another discharge lamp. The light source 3 may be a light source other than a discharge lamp, for example, a solid light source such as a light-emitting diode (LED).

Although the three light sources 3 are provided in the first housing 2a, one or two light sources 3 may be provided in the first housing 2a, or four or more light sources 3 may be provided therein. In the present embodiment, the plurality of light sources 3 are disposed side by side in the conveyance direction (Y direction) of the treatment object 4, but the plurality of light sources 3 may be disposed side by side in the X direction, or the light sources 3 may be disposed side by side in each of the X direction and the Y direction.

The width of the light source 3 in the X direction is preferably larger than the width of the treatment object 4 in the X direction. Thus, the light L1 can be uniformly emitted in the width direction from the center to the end of the treatment object 4. Considering that the position of the treatment object 4 in the X direction may change due to meandering of the belt 7 when the treatment object 4 is conveyed, the width of the light source 3 in the X direction is preferably 50 mm to 100 mm larger than the width of the treatment object 4 in the X direction. For example, in a case where the width of the treatment object 4 in the X direction is 500 mm, the width of the light source 3 in the X direction is preferably 550 mm to 600 mm.

The illuminance of light applied to the treatment object 4 (conveyance path) may be changed by moving the light source 3 closer to or away from the treatment object 4. In addition, a desired light reduction filter may be disposed in the light source 3 so that the illuminance can be changed. A reflector or a reflection layer that reflects ultraviolet light may be formed on the inner wall of the first housing 2a. The light L1 emitted from the light source 3 is directed in the -Z direction by the reflector or the reflection layer.

In a case where the light source 3 is disposed in the second housing 2b, the description regarding the light source 3 described above is also applied to the light source 3 disposed inside the second housing 2b.

### [Gas supply port]

Details of the gas supply port 8 will be described with reference to Fig. 1. The first housing 2a and the second housing 2b each include a plurality of the gas supply ports 8 inside the housing. The gas supplied from the gas supply port 8 is preferably an inert gas IG (for example, nitrogen gas). The gas supply port 8 supplies the inert gas IG into the housing to form an inert gas atmosphere. The gas supply port 8 is connected to a gas supply source 12 that supplies the inert gas IG via a gas pipe 6. There is a flow rate adjustment valve 17 in the middle of the gas pipe 6. In the present embodiment, a nitrogen gas is used as the inert gas IG, but an inert gas other than the nitrogen gas may be used.

By forming the inert gas atmosphere, the environment in the space constituted by the first housing 2a and the second housing 2b can be stabilized. In particular, in a case where the vacuum ultraviolet light is used for the light L1, the formation of the inert gas atmosphere contributes to suppressing absorption of the light L1 by oxygen in the air and improving the illuminance of the light L1 in the treatment object 4.

In the present specification, unless otherwise specified, the "inert gas atmosphere" refers to a mixed gas in which the inert gas IG occupies 90 vol% or more of the whole inside of the housing (2a, 2b). At this time, an oxygen concentration inside the housing (2a, 2b) is reliably less than 10 vol%. For example, when the ultraviolet light of 172 nm travels 4 mm in a space where the oxygen concentration is less than 10%, light intensity of 50% or more can be secured. The inert gas IG preferably occupies 95 vol% or more in the housing (2a, 2b). At this time, the oxygen concentration inside the housing is reliably less than 5%. For example, when the ultraviolet light of 172 nm travels 4 mm in a space where the oxygen concentration is less than 5%, light intensity of 70% or more can be secured. The concentration of the inert gas inside is more preferably 98 vol% or more.

Details of the gas supply port 8 provided in the housing (2a, 2b) will be described. In the present embodiment, the gas supply port 8 may be designed to supply the inert gas IG along a plane (XY plane) including the conveyance direction of the treatment object 4 and not to inject the inert gas IG toward the treatment object 4. With this configuration, the injected inert gas IG can be prevented from colliding with the treatment object 4, and the gas in the atmosphere can be prevented from being turbulent in the housing (2a, 2b). When the gas becomes turbulent in the housing (2a, 2b), the gas easily enters the housing (2a, 2b) from the outside of the housing (2a, 2b). Note that the supply direction of the gas supply port 8 may be inclined from the XY plane to such an extent that the inert gas IG is not injected toward the treatment object 4.

As shown in Fig. 1, the plurality of gas supply ports 8 are disposed at substantially equal intervals in the conveyance direction. At this time, the amount of inert gas supply from the gas supply ports 8 is preferably set to substantially the same amount. This can suppress the formation of the turbulent flow in the housing (2a, 2b).

As shown in Figs. 2A and 2B, the gas supply port 8 is provided in an elongated member elongated in the X direction. A plurality of holes is disposed side by side in the X direction in the member. This enables the inert gas to be uniformly supplied in the width direction (X direction). Alternatively, the gas supply port 8 may be a slit-shaped gas supply port elongated in the X direction.

Referring to Fig. 1, the plurality of gas supply ports 8 are connected to the gas supply source 12 via the gas pipe 6. The gas pipe 6 is branched as necessary. The flow rate adjustment valve 17 is provided in the middle of the gas pipe 6. Note that, in the present invention, the gas supply port 8 is not an essential component, and the gas supply port 8 may be used as necessary.

The gas supply port 8 may be provided only in any one of the first housing 2a and the second housing 2b. Even when the gas supply port 8 is provided only in any one of the first housing 2a and the second housing 2b, the gas supplied from the gas supply port 8 flows around the treatment object 4 and the belt 7, and the atmosphere gas in the housing on the side where the gas supply port 8 is not provided can be replaced.

### [Gas recovery chamber]

The gas recovery chamber will be described with reference to Fig. 1. The light treatment device 100 includes a gas recovery chamber (20a, 20b) that recovers a gas on the upstream side (+Y direction) of the housing (2a, 2b) in the conveyance path. The gas recovery chamber 20a is located on the light irradiation surface side (+Z side) of the treatment object 4. The gas recovery chamber 20b is located on the opposite side (-Z side) to the light irradiation surface side of the treatment object 4. The gas recovery chamber 20b and the gas recovery chamber 20a are at positions facing each other across the treatment object 4. The light treatment device 100 includes a gas recovery chamber (30a, 30b) that recovers a gas on the downstream side (-Y direction) of the housing (2a, 2b) in the conveyance path. The gas recovery chamber 30a is located on the light irradiation surface side (+Z side) of the treatment object 4. The gas recovery chamber 30b is located on the opposite side (-Z side) to the light irradiation surface side of the treatment object 4. The gas recovery chamber 30b and the gas recovery chamber 30a are at positions facing each other across the treatment object 4.

The gas recovery chamber 20a is a housing having an opening in a direction approaching the treatment object 4 (-Z direction). The gas recovery chamber 20a may have a plurality of gas recovery ports disposed in the housing. The plurality of gas recovery ports may be formed by disposing a porous plate (not illustrated) in the gas recovery chamber 20a. The plurality of gas recovery ports is preferably connected to a common exhaust port 23. The exhaust port 23 is connected to an exhaust source not illustrated in Fig. 1. The gas recovery chambers (20b, 30a, 30b) may have a structure similar to or different from the structure of the gas recovery chamber 20a.

The inert gas IG inside the first housing 2a and the second housing 2b leaks toward the upstream side or downstream side of the first housing 2a and the second housing 2b via the carry-in opening 5i or the carry-out opening 5o. The gas recovery chambers (20a, 20b, 30a, 30b) recover the leaking inert gas IG. This protects a person in the vicinity of the light treatment device 100 from the oxygen deficiency. Note that, in a case where there is no person in the vicinity of the light treatment device 100 or in a case where there is an exhaust facility not belonging to the light treatment device 100, the light treatment device 100 may not have the gas recovery chamber. That is, in the light treatment device 100, the gas recovery chambers (20a, 20b, 30a, 30b) are not an essential configuration.

The light treatment device may include only one of the gas recovery chamber (20a, 20b) on the upstream side of the housing (2a, 2b) and the gas recovery chamber (30a, 30b) on the downstream side of the housing (2a, 2b).

The oxygen concentration inside the housing (2a, 2b) may be measured by one or more oxygen concentration meters, and the supply amount of the inert gas IG may be adjusted according to the measured oxygen concentration, or the exhaust amount of the gas recovery chambers (20a, 20b, 30a, 30b) may be adjusted. The oxygen concentration meter and the supply amount adjustment mechanism or the exhaust amount adjustment mechanism of the inert gas IG may be connected by a control unit to cause the control unit to automatically control the oxygen concentration.

### [Treatment object]

The treatment object of the present embodiment may be a substrate used for a flat panel display (FPD) or the like. In a case where the substrate is an inorganic material such as glass, it is particularly preferable to irradiate the entire surface of the substrate with the light L1 for photo-cleaning of the substrate. In a case where the substrate is a film of such as resin, it is particularly preferable to irradiate the entire surface of the substrate with the light L1 for modification of the substrate. In a case where the substrate is a metal sheet used for a fuel cell or the like, the metal sheet may be irradiated with the light L1 in order to clean the metal sheet or to impart a matte effect to the metal sheet. As another example of the treatment object 4, a sheet-like decorative sheet may be used. By modifying the surface of the resin on the surface of the decorative sheet, the matte effect may be imparted to the surface.

In a case where the treatment object 4 has a sheet shape, the treatment object 4 may be conveyed by, for example, a roll-to-roll method. In the roll-to-roll method, a sheet-like treatment object is unwound from a roll of the treatment object 4 wound in an unwinding device (not illustrated), the treatment object 4 is conveyed along the conveyance path, and the treatment object 4 is wound in a winding device (not illustrated). In the conveyance path, the treatment object 4 is supported by a plurality of the guide rollers 33. That is, in a case where the treatment object has a sheet shape, the belt 7 may be omitted.

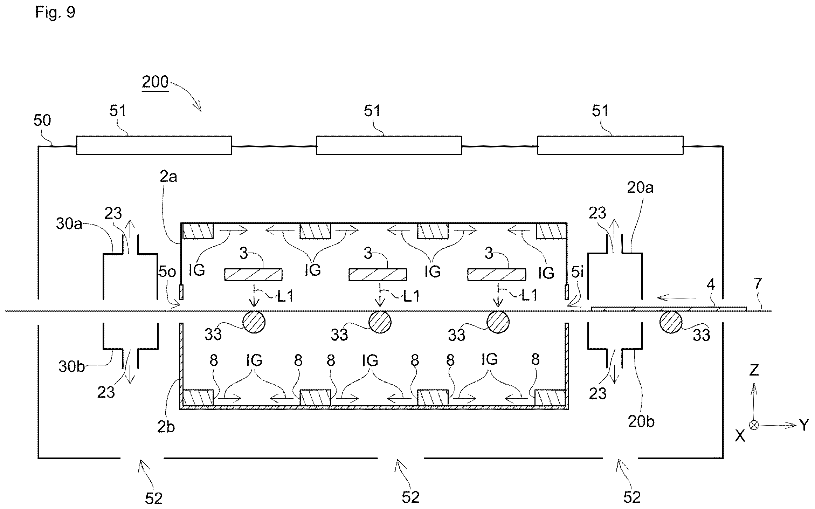

Fig. 9 is a diagram illustrating another embodiment of a light treatment device. The light treatment device 200 includes an outer housing 50 provided so as to surround a housing (2a, 2b) and recovery chambers (20a, 20b, 30a, 30b). A plurality of fan filter units (FFUs) 51 is attached to a ceiling (wall on the +Z direction side) of the outer housing 50. A plurality of FFUs 51 pump gas outside the outer housing 50 into the outer housing 50. The fed gas forms a downflow and is discharged from the plurality of holes 52 provided in the floor (wall on the -Z direction side) of the outer housing 50. As shown in the drawing, a gap may be formed between the housing (2a, 2b) and the recovery chamber (20a, 20b, 30a, 30b).

Although the embodiments of the light treatment device and modifications thereof have been described above, the present invention is not limited to the above-described embodiments at all, and various changes and improvements may be made to the embodiments without departing from the spirit of the present invention.

For example, the light treatment device described above includes only one space including the first housing 2a and the second housing 2b, but may include a housing for forming a further light treatment space on the upstream side or the downstream side in the conveyance direction of the first housing 2a and the second housing 2b.

For example, in the light treatment device described above, the irradiation direction of the light L1 is the same direction as the gravity direction (-Z direction), but the irradiation direction of the light L1 may be different from the gravity direction. For example, the ultraviolet light may be irradiated in the horizontal direction on a conveyance body conveyed in the direction of gravity.

### DESCRIPTION OF REFERENCE SIGNS

2a: first housing
2b: second housing
2b1: main body (constituting second housing)
2b2: band member (constituting second housing)
3: light source
4: treatment object
5i: carry-in opening
5o: carry-out opening
6: gas pipe
7 : belt
8: gas supply port
12: gas supply source
17: flow rate adjustment valve
20: band region
20a, 20b, 30a, 30b: gas recovery chamber
20b: gas recovery chamber
21: region (faces across band area across a carry-in opening)
22: light shield
23: exhaust port (of a gas recovery chamber)
24: recess (of band member)
26, 27: end (of band member)
33: guide rollers
40: groove (of band member)
41: through hole (of band member)
42: head bolt
43: flange (of band member)
45: portion (of band member)
46: sliding guide
50: outer housing
52: hole (of outer housing)
100, 200: light treatment device
F1: engagement mechanism
IG: inert gas
L1: light

## Claims

1. A light treatment device (100) comprising:
a light source (3) that irradiates a treatment object (4) conveyed along a conveyance path with ultraviolet light (L1);
a housing (2a, 2b) having the light source (3) in an inside and having an opening (5i, 5o) through which the treatment object (4) is carried in or out; and
a heat deflection reducer that reduces heat deflection of the housing (2a, 2b) surrounding the opening (5i, 5o).

2. The light treatment device (100) according to claim 1, wherein
the housing (2a, 2b) includes a first housing (2a) having the light source (3) in an inside and a second housing (2b) having a space in which the treatment object (4) is irradiated with the ultraviolet light (L1), and
the opening (5i, 5o) is provided in the second housing (2b).

3. The light treatment device (100) according to claim 2, wherein
the opening (5i, 5o) has a shape that is short in a thickness direction of the treatment object (4) and is long in a width direction of the treatment object (4), and
the second housing (2b) includes a band region (20) sandwiched between the opening (5i, 5o) and an end of the second housing (2b).

4. The light treatment device (100) according to claim 3, wherein
the band region (20) includes a band member (2b2) that is separate from a main body (2b1) constituting a portion excluding the band region (20),
the heat deflection reducer includes an engagement mechanism (F1) that loosely engages the band member (2b2) with the main body (2b1), and
while releasing shift caused by thermal expansion of the band member (2b2) in an extending direction, the engagement mechanism (F1) restricts shift caused by the thermal expansion in a direction orthogonal to the extending direction of the band member (2b2).

5. The light treatment device (100) according to claim 3 or 4, wherein
the heat deflection reducer includes a heater that heats a region in the first housing (2a), the region facing the band region (20) across the opening (5i, 5o).

6. The light treatment device (100) according to claim 3 or 4, wherein
the heat deflection reducer includes a cooler that cools the band region (20).

7. The light treatment device (100) according to claim 3 or 4, wherein
the heat deflection reducer includes a light shield (22) inserted between the band region (20) and the light source (3).
